# FASCICULE DE BREVET EUROPEEN

(11) **EP 0 432 057 B1**
(45) Date de publication et mention de la délivrance du brevet: **25.05.1994**
(21) Numéro de dépôt: 90420506.9
(22) Date de dépôt: 22.11.1990
(51) Int. Cl.: H01L 23/556, H01L 27/11, H01L 27/092

(54) **Circuit intégré comprenant des mémoires et son procédé de fabrication**
Integrierte Schaltung mit Speicher und ihr Herstellungsverfahren
Integrated circuit comprising memories and method for its fabrication

(30) Priorité: 28.11.1989 FR 8916007
(43) Date de publication de la demande: 12.06.1991
(73) Titulaire: SGS-THOMSON MICROELECTRONICS S.A., 94250 Gentilly (FR)
(72) Inventeur: Bergemont, Albert, F-38000 Grenoble (FR)
(74) Mandataire: de Beaumont, Michel

(56) Documents cités:
- EP-A- 0 018 764
- EP-A- 0 319 047
- US-A- 4 706 107
- PATENT ABSTRACTS OF JAPAN, vol. 8, no. 155 (E-256)[1592], 19 juillet 1984; & JP-A-59 58 860

## Description

La présente invention concerne des circuits intégrés comprenant des zones de mémoires vives statiques ou dynamiques (mémoires SRAM ou DRAM).

Une des difficultés de réalisation des mémoires vives est liée au fait que celles-ci sont sensibles aux porteurs minoritaires parasites générés dans le substrat ou les zones actives et qui peuvent venir s'accumuler dans certaines zones de la mémoire, y modifier le potentiel et entraîner ainsi un changement d'état logique d'au moins un point de cette mémoire.

Ces porteurs minoritaires sont susceptibles d'être générés par des particules alpha qui induisent dans le substrat en silicium des paires électron-trou, ou bien, lors de la lecture, du fait que le transistor d'accès crée, en régime de saturation, de tels porteurs minoritaires dans sa zone active par le phénomène bien connu d'ionisation par impact.

Dans le cas d'une mémoire RAM dynamique, les porteurs minoritaires parasites peuvent par exemple venir décharger la capacité de stockage et modifier ainsi l'état logique du point mémoire.

Dans le cas d'une mémoire RAM statique, les porteurs minoritaires parasites peuvent faire changer d'état la bascule bistable d'un point mémoire si les charges créées viennent trop rapidement s'accumuler au niveau de la résistance de haute valeur présente dans le point mémoire de structure classique comprenant quatre transistors.

Dans la suite de cet exposé, pour faciliter la compréhension, on se limitera à l'exemple de réalisation d'un point mémoire RAM statique à quatre transistors comprenant deux résistances à haute valeur. L'invention n'est bien évidemment pas limitée à ce type de mémoire et concerne l'ensemble des mémoires RAM statiques et dynamiques.

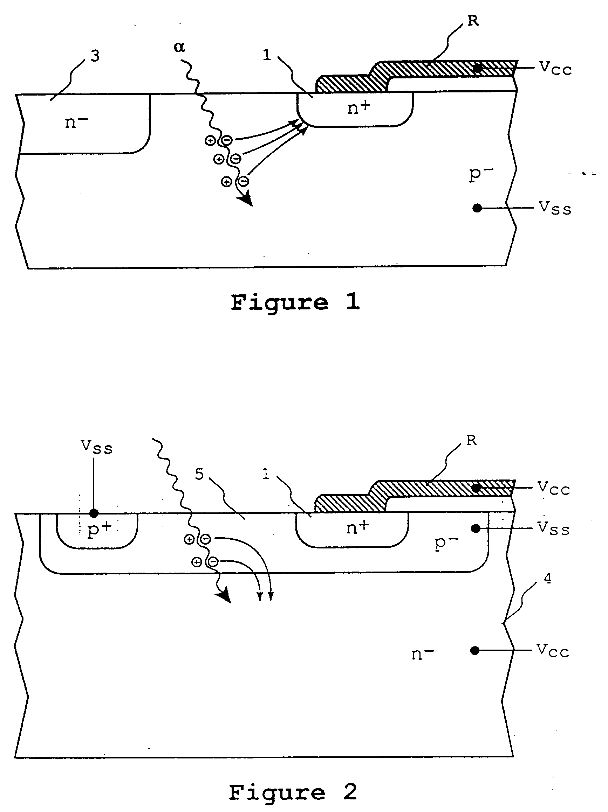

Les inconvénients des structures classiques vont être rappelés en relation avec les figures 1 et 2.

Dans la figure 1, on n'a pas représenté l'ensemble des éléments constitutifs d'un point mémoire SRAM classique mais seulement, très localement, la zone de prise de contact 1 de l'une des deux résistances haute valeur R qui constitue l'un des éléments constitutifs d'un point mémoire classique SRAM à quatre transistors MOS. L'objet de cette figure n'est pas d'illustrer la structure d'une mémoire mais simplement d'illustrer les effets néfastes de porteurs minoritaires parasites.

La figure 1 représente une structure réalisée dans un substrat p⁻2 dans lequel sont disposés des caissons n⁻ 3. Cette figure illustre l'effet d'une particule alpha qui crée des paires électrons-trous. Les charges négatives, c'est-à-dire les électrons, affluent en direction de la zone n⁺ 1 sur laquelle vient se prendre le contact électrique de la résistance haute valeur R. La raison pour laquelle ces électrons convergent vers la zone n⁺ 1 réside dans le fait que la zone p⁻ dans laquelle les porteurs minoritaires sont créés est classiquement portée à un potentiel Vss (par exemple la masse) inférieur au potentiel Vcc (par exemple 5 volts) de la résistance haute valeur R. Dans une mémoire SRAM classique à quatre transistors, la zone de contact 1 est connectée à la fois au drain d'un des deux transistars de la bascuLe et à la grille de l'autre transistor. Si une trop grande quantité de porteurs minoritaires est créée dans le substrat p⁻ 2, ces porteurs minoritaires peuvent venir modifier le potentiel de la zone de contact 1 et peuvent ainsi faire basculer de façon intempestive la bascule.

Pour remédier à certains inconvénients, on a proposé, comme cela est représenté en figure 2, d'utiliser, au lieu d'un substrat p⁻, un substrat n⁻ 4 à la surface duquel est crée un caisson p⁻ 5 dans lequel est réalisé le point mémoire (cf. Patent Abstracts of Japan, Vol.8, Nr.155 (E-256)[1592] et JP-A-59 58 860). Dans ce cas, le substrat 4 est porté au potentiel Vcc et le caisson p⁻ 5 est porté au potentiel Vss. Les électrons créés dans le caisson 5 se retrouvent alors attirés préférentiellement en direction du substrat 4 sous-jacent. Il en résulte une très nette diminution du courant électrique susceptible de modifier le potentiel de la zone de contact 2.

Si cette technique est efficace, elle n'est pas applicable dans tous les cas. En particulier, lorsque l'on veut réaliser un circuit intégré comprenant à la fois des circuits logiques, généralement réalisés en technique CMOS, et des circuits constituant des mémoires, par exemple une mémoire SRAM, il est apparu préférable d'utiliser un substrat dopé p⁻ dans lequel on réalise localement des caissons dopés n⁻. En effet, dans une technologie CMOS, on sait que la vitesse d'un transistor MOS est directement liée au niveau de dopage de son substrat (ou caisson). Plus le dopage du substrat est faible, plus le transistor est rapide. Quand on forme un caisson dans un substrat du type de conductivité opposé, ce caisson qui est inévitablement plus dopé que le substrat entrainera que les transistors qui y sont formés sont de façon inhérente plus lents. Il est donc préférable de réaliser les transistors à canal n directement dans un substrat p⁻ plutôt que dans un caisson de type p formé dans un substrat n⁻.

US-A-4 706 107 décrit des points mémoire formés dans des zones p⁻ déposées sur un substrat n⁺, les zones p⁻ sont classiquement séparées les unes des autres par des régions isolantes.

La présente invention vise donc à fabriquer un circuit mémoire qui soit réalisable dans un substrat de type p, pour les avantages décrits ci-dessus, et qui soit également peu sensible aux effets néfastes des porteurs minoritaires parasites.

L'invention concerne donc un circuit intégré comprenant des mémoires, tel qu'il ressort de la revendication 1.

Selon une autre caractéristique de l'invention, la mémoire constituant le circuit intégré est de type RAM statique.

Selon une autre caractéristique de l'invention, la mémoire constituant le circuit intégré est une mémoire de type RAM dynamique.

L'invention concerne également le procédé de fabrication dudit circuit intégré comprenant des mémoires.

Selon une autre caractéristique de l'invention, ce procédé de fabrication comprend les étapes suivantes :
- sur un substrat constitué d'une plaquette de silicium monocristallin dopée n⁺, réaliser une couche mince dopée p⁻,
- déposer une résine photosensible, l'insoler et la développer de façon à n'en conserver que des îlots disposés dans les zones dans lesquelles seront réalisées ultérieurement les transistors des points mémoire,
- effectuer une implantation ionique supplémentaire de façon à transformer la couche p⁻ en couche n⁻ dans toutes les zones non recouvertes par la résine, et
- réaliser les transistors des points mémoires dans lesdites zones restantes de type p⁻.

Selon une autre caractéristique de l'invention, dans le cas où le circuit intégré associe sur la même puce un circuit mémoire et un circuit de type CMOS, le procédé de fabrication prévoit également que les transistors à canal n et les transistors à canal p du circuit CMOS sont réalisés respectivement dans des zone de ladite couche dopée p⁻ et dans des zones transformées par l'implantation ionique en le type n⁻.

Ces objets, caractéristiques et avantages ainsi que d'autres de la présente invention seront exposés plus en détail dans la description suivante de modes de réalisation particuliers faite en relation avec les figures jointes dans lesquelles :
la figure 1 représente schématiquement et partiellement un point mémoire selon l'art antérieur ;
la figure 2 représente schématiquement et partiellement le même point mémoire comportant en outre un perfectionnement selon l'art antérieur ;
la figure 3 représente une étape du procédé selon l'invention ; et
la figure 4 représente une étape suivante du procédé selon l'invention.

Ces diverses figures ne sont pas représentées à l'échelle, ni d'une figure à l'autre, ni à l'intérieur d'une figure, et notamment les épaisseurs des couches sont dessinées arbitrairement dans le but de faciliter la lecture des figures.

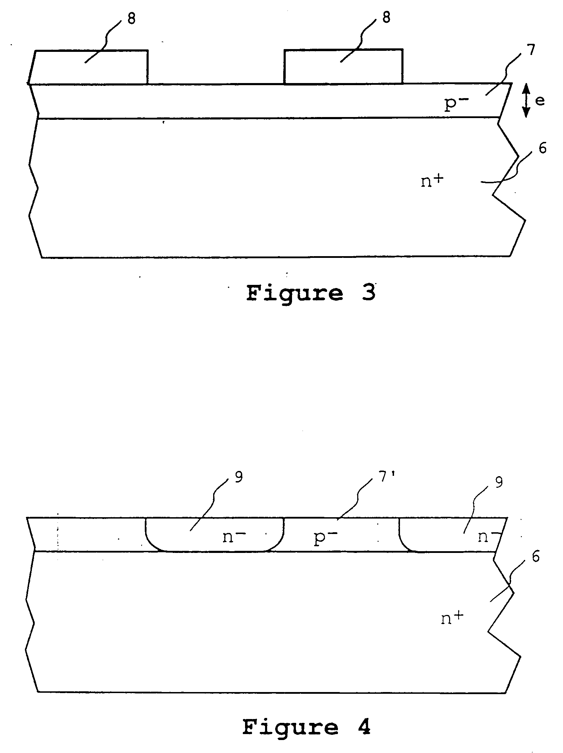

Les figures 3 et 4 illustrent des étapes successives de fabrication d'un circuit mémoire selon l'invention.

Dans le procédé de fabrication selon l'invention, on part d'un substrat constitué d'une tranche de silicium mono-cristallin 6 dopée n⁺. On réalise, à la surface de cette tranche n⁺ 6, une couche de faible épaisseur dopée p⁻ 7. Une telle couche 7 peut être réalisée, de préférence, par croissance épitaxiale.

Ensuite, on dépose une couche de résine photosensible, on l'insole et on la développe de façon à ne conserver que des îlots de résine 8 en des endroits particuliers de la plaquette. On procède alors à une implantation ionique destinée à transformer la couche 7, dans les zones non recouvertes par les îlots de résine 8, en une couche 9 dopée n⁻. L'épaisseur de la couche épitaxiée 7, l'énergie d'implantation ionique n et la dose ainsi implantée sont choisies de façon que, pendant la diffusion du caisson n⁻ jusqu'à la zone n⁺ sous-jacente, cette région n⁺ ne remonte pas trop vers la surface de manière à conserver des concentrations identiques à celles utilisées dans une technologie classique utilisant un substrat p⁻ et un caisson n⁻.

Les zones dopées p⁻ restantes constituent ainsi des pseudo-caissons p⁻ 7′ dans un substrat de type n. On voit que dans ces pseudo-caissons p⁻ on peut réaliser sans problème des points mémoire de type RAM statiques ou dynamiques, et qu'il est en même temps possible de réaliser sur le même substrat d'autres zones de caisson n⁻ servant à la réalisation des transistors à canal p d'une partie de circuit en technologie CMOS, les transistors à canal n de cette partie de circuit en technologie CMOS étant réalisés directement dans la couche p⁻.

La région n⁺ 6 du substrat est portée au potentiel Vcc et les pseudo-caissons p⁻ 7′ sont portés au potentiel Vss. En polarisant ainsi le substrat, les électrons parasites éventuellement générés dans les pseudo-caissons p⁻ 7′ vont préférentiellement vers la zone sous-jacente 6 et ne pertubent pratiquement pas les circuits disposés dans ces pseudo-caissons.

### EXEMPLE

On a réalisé une structure conforme à la figure 4, à partir d'un substrat n⁺ dopé à l'arsenic à 2 10¹⁸ at./cm³, sur lequel on a fait croître par épitaxie une couche p⁻ de dopage 1 10¹⁵ at/cm³ sur une épaisseur de 4 micromètres. On a ensuite effectué une implantation ionique de phosphore à une énergie de 100 keV et avec une dose de 10¹³ atomes/cm². Dans ces conditions, on a pu créer des zones n⁻ 9 d'une concentration d'environ 10¹⁶ at./cm³ dans la couche épitaxiée 7, ces zones n⁻ 9 touchant directement la zone sous-jacente n⁺ du substrat 6 et les zones non implantées de la couche 7 subsistant dans leur état de dopage p⁻.

Bien entendu, la présente invention est susceptible nombreuses variantes qui apparaîtront à l'homme de l'art en ce qui concerne les types de dopant utilisables.

## Revendications

1. Circuit intégré comprenant des mémoires dans lequel: le substrat sur lequel sont réalisés des transistors des points mémoire est constitué d'un substrat dopé n⁺ (6) muni à sa surface d'une couche dopée p⁻ (7) de faible épaisseur;
la couche p⁻ (7) est divisée en zones distinctes (7′) séparées par des régions de type n⁻ (9) s'étendant jusqu'au substrat dopé n⁺ (6),
les transistors constituant les points mémoire sont réalisés dans des premières desdites zones distinctes (7′),
le circuit intégré comprend en outre des transistors MOS complémentaires dont les transistors à canal p sont réalisés dans certaines des régions de type n⁻ (9) et les transistors à canal n sont réalisés dans des secondes desdites zones distinctes (7′).

2. Circuit intégré comprenant des mémoires selon la revendication 1, caractérisé en ce que ladite mémoire est du type RAM statique.

3. Circuit intégré comprenant des mémoires selon la revendication 1, caractérisé en ce que ladite mémoire est de type RAM dynamique.

4. Procédé de fabrication d'un circuit intégré comprenant des mémoires, comprenant les étapes suivantes :
- sur un substrat constitué d'une plaquette de silicium monocristallin dopée n⁺ (6), réaliser une couche mince dopée p⁻ (7),
- déposer une résine photosensible, l'insoler et la développer de façon à n'en conserver que des îlots (8) disposés au niveau des zones dans lesquelles seront réalisés par la suite les transistors des points mémoire,
- effectuer une implantation ionique de façon à transformer sur toute son épaisseur la couche p⁻ en couche n⁻ dans toutes les zones (9) non recouvertes par la résine (8), et
- réaliser les transistors des points mémoire dans lesdites zones dopées p⁻ (7).

5. Procédé de fabrication de circuit intégré selon la revendication 4, ce circuit intégré comprenant en outre au moins un circuit de type CMOS, caractérise en ce que les transistors à canal n et les transistors à canal p du circuit CMOS sont réalisés respectivement dans les zones de ladite couche dopées p⁻ (7) et dans les zones transformées par ladite implantation ionique et dopées n⁻ (9).

6. Procédé de fabrication de circuit intégré selon la revendication 4, caractérisé en ce que ladite couche mince dopée p⁻ (7) est formée par épitaxie.

## Patentansprüche

1. Integrierte Schaltung mit Speichern, in der: das Substrat, auf dem Speicherpunkttransistoren gebildet sind, aus einem n⁺-dotierten Substrat (6) aufgebaut ist, das an seiner Oberfläche mit einer p⁻-dotierten Schicht (7) geringer Dicke versehen ist;
die p⁻-Schicht (7) in verschiedene Zonen (7′) aufgeteilt ist, die durch Bereiche vom n⁻-Typ (9) voneinander getrennt sind, welche sich bis zu dem n⁺-dotierten Substrat (6) erstrecken,
die Transistoren, die die Speicherpunkte bilden, in ersten der verschiedenen Zonen (7′) gebildet sind,
die integrierte Schaltung weiterhin komplementäre MOS-Transistoren aufweist, wobei die p-Kanal-Transistoren in bestimmten der n⁻-Typ-Bereiche (9) gebildet sind und die n-Kanal-Transistoren in zweiten der verschiedenen Zonen (7′) gebildet sind.

2. Integrierte Schaltung mit Speichern nach Anspruch 1, dadurch gekennzeichnet, daß der Speicher vom Typ eines statischen RAM ist.

3. Integrierte Schaltung mit Speichern nach Anspruch 1, dadurch gekennzeichnet, daß der Speicher vom Typ eines dynamischen RAM ist.

4. Verfahren zum Herstellen einer integrierten Schaltung mit Speichern, mit den folgenden Schritten:
- auf einem Substrat, das aus einem Plättchen aus n⁺-dotiertem, monokristallinem Silizium (6) aufgebaut ist, Bilden einer dünnen p⁻dotierten Schicht (7),
- Ablagern eines lichtempfindlichen Harzes, Belichten desselben und Entwickeln desselben derart, daß davon nur Inseln (8) erhalten bleiben, die auf der Höhe der Zonen angeordnet sind, in denen im folgenden die Speicherpunkttransistoren gebildet werden,
- Durchführen einer Ionenimplantation, um über ihre gesamte Dicke die p⁻-Schicht in eine n⁻-Schicht in allen Zonen (9) umzuwandeln, die nicht von dem Harz bedeckt sind, und
- Bilden der Speicherpunkttransistoren in den p⁻-dotierten Zonen (7).

5. Verfahren zum Herstellen einer integrierten Schaltung nach Anspruch 4, wobei diese integrierte Schaltung weiterhin wenigstens eine Schaltung vom CMOS-Typ aufweist, dadurch gekennzeichnet, daß die n-Kanal-Transistoren und die p-Kanal-Transistoren der CMOS-Schaltung jeweils in den Zonen der p⁻-dotierten Schicht (7) und in den durch die Ionenimplantation umgewandelten und n⁻-dotierten Zonen (9) gebildet werden.

6. Verfahren zum Herstellen einer integrierten Schaltung nach Anspruch 4, dadurch gekennzeichnet, daß die dünne, p⁻-dotierte Schicht (7) durch Epitaxie gebildet wird.

## Claims

1. An integrated circuit comprising memories, wherein:
the substrate in which are formed the transistors of the memory points is constituted by an n⁺-doped substrate (6) provided at its surface with a shallow p⁻-doped layer (7);
the p⁻- layer (7) is divided into distinct areas (7′) separated by n⁻-type regions (9) extending down to the n⁺-doped substrate (6);
the transistors constituting the memory points are formed into first of said distinct areas (7′);
the integrated circuit further comprises CMOS transistors, wherein the p-channel transistors of the CMOS circuit are formed in some n⁻- doped areas (9), and the n-channel transistors are formed in second of said distinct areas (7′).

2. An integrated circuit comprising memories according to claim 1, characterized in that said memory is of the static RAM type.

3. An integrated circuit comprising memories according to claim 1, characterized in that said memory is of the dynamic RAM type.

4. A process for manufacturing an integrated circuit comprising memories, comprising the following steps:
- forming a p⁻ doped thin layer (7) on a substrate constituted by an n⁺ single-silicon wafer (6),
- depositing, lighting and etching a photoresist so as to maintain only small islands (8) arranged in areas wherein the transistors of the memory points will subsequently be formed,
- implanting an additional dopant so as to transform on its whole thickness the p⁻ layer into an n⁻ layer in all the areas (9) not coated with the resist (8), and
- forming transistors of memory points in said p⁻-type doped areas (7).

5. A process for manufacturing an integrated circuit according to claim 4, said integrated circuit further comprising at least one CMOS-type circuit, wherein said n-channel transistors and p-channel transistors of the CMOS circuit are respectively formed in areas of said p-doped area (7) and in the n⁻ doped areas (9) transformed through said ion implantation.

6. A process for manufacturing an integrated circuit according to claim 4, characterized in that said p⁻-doped thin layer (7) is epitaxied.
